(19)

Europäisches
Patentamt
European
Patent Office
Office européen
des brevets

(11)  **EP 0 880 073 B1**

(12)  **EUROPEAN PATENT SPECIFICATION**

(45) Date of publication and mention
of the grant of the patent:
**20.08.2008 Bulletin 2008/34**

(51) Int Cl.:
*G03F 1/14* (2006.01)      *C23C 16/26* (2006.01)

(21) Application number: **98304053.6**

(22) Date of filing: **21.05.1998**

(54) **Diamond films suitable for x-ray lithography and their manufacture**

Für die Röntgenstrahllithographie geeignete Diamantfilme sowie ein Verfahren zu deren Herstellung

Films en diamant utilisables pour la lithographie aux rayons X ainsi qu'un procédé pour leur fabrication

(84) Designated Contracting States:
**DE FR GB**

(30) Priority: **21.05.1997 JP 14712097**
**01.08.1997 JP 22083797**

(43) Date of publication of application:
**25.11.1998 Bulletin 1998/48**

(73) Proprietor: **Shin-Etsu Chemical Co., Ltd.**
**Chiyoda-ku,**
**Tokyo (JP)**

(72) Inventor: **Noguchi, Hitoshi**
**2-13-1, Isobe,**
**Annaka-shi,**
**Gunma-ken (JP)**

(74) Representative: **Stoner, Gerard Patrick et al**
**Mewburn Ellis LLP**
**York House**
**23 Kingsway**
**London WC2B 6HP (GB)**

(56) References cited:
**EP-A- 0 762 466**          **US-A- 5 405 645**

• **GOMEZ-ALEIXANDRE C ET AL: "Influence of oxygen on the nucleation and growth of diamond films" THIN SOLID FILMS, vol. 303, no. 1-2, 15 July 1997, page 34-38 XP004087609**
• **SCHAEFER L ET AL: "DIAMOND MEMBRANES WITH CONTROLLED STRESS FOR SUBMICRON LITHOGRAPHY" DIAMOND AND RELATED MATERIALS, vol. 2, no. 8, 15 May 1993, pages 1191-1196, XP000381404**
• **RAVET M F ET AL: "APPLICATION OF DIAMOND THIN FILMS TO X-RAY LITHOGRAPHY MASKS" PROCEEDINGS OF THE INTERNATIONAL COLLOQUIUM ON PLASMA PROCESSES, ANTIBES, JUAN LES PINS, JUNE 6 - 11, 1993, no. COLLOQUE 9, 6 June 1993, pages 237-239, XP000399252 SOCIETE FRANCAISE DU VIDE**
• **SANCHEZ O. ET AL: "Study of the plasma discharges in diamond deposition with different O2 concentrations" DIAMOND AND RELATED MATERIALS, vol. 3, 1994, pages 1183-1187,**

**Description**

This invention relates to a diamond film for x-ray lithography and a method for preparing the same.

BACKGROUND

As the manufacture of advanced semiconductor devices requires finer patterning, x-ray lithography is considered promising in the future.

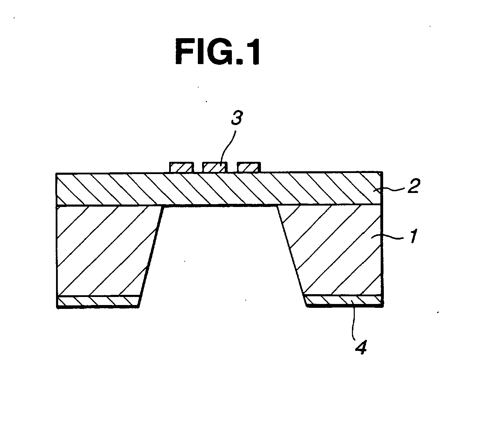

A mask used in x-ray lithography has a structure as shown in FIG. 1. The mask includes a support substrate 1, a x-ray transmissive membrane 2 disposed on one surface of the substrate 1, an x-ray absorbing pattern 3 carried on the membrane 2, and a surface protective film 4 disposed on another surface of the substrate 1. The membrane 2 must have the properties of (1) high mechanical strength, (2) resistance to irradiation of high-energy beams such as high-energy electron beams and synchrotron orbital radiation (SOR), and (3) high transmittance to visible light as needed for high precision filaments.

Heretofore, BN, boron drope, Si, SiN, SiC, diamond, etc. have been proposed as the mask membrane material for x-ray lithography. Among these, diamond satisfying the above-mentioned properties (1) to (3) is regarded optimum as the mask membrane material for x-ray lithography.

The membrane must be a self-supporting film, typically 2 to 3 $\mu$m thick, in order to minimize the absorption of x-rays. In order for the membrane to be self-supporting, the film desirably has a tensile stress in the range of 0.0 to $4.0 \times 10^8$ Pa

In general, diamond films are prepared by microwave plasma chemical vapor deposition (CVD) and hot filament CVD processes because these processes relatively easily form diamond films of good crystallinity over large areas. For example, the diamond film preparation method which is most commonly employed in the prior art relies on the microwave plasma CVD process using hydrogen-diluted methane as a source gas. If deposition is carried out at a low methane concentration, a diamond film of good crystallinity is obtained, but the film is always compressively stressed. Despite good crystallinity, the film cannot be self-supporting. Such a film cannot be utilized as the x-ray mask. Conversely, if deposition is carried out at a high methane concentration, a diamond film having tensile stresses produced therein is obtained at the sacrifice of crystallinity. Since the microwave plasma CVD and hot filament CVD processes utilize plasma, many film deposition parameters are correlated to plasma conditions. It is quite difficult to form a diamond film with levels of crystallinity and film stress which are suitable for function as an X-ray mask.

The aim herein is to provide new methods of diamond film formation apt to produce diamond films suitable for use in X-ray lithography, as well as the diamond films produced thereby, X-ray lithography masks including them and use thereof in X-ray lithography.

A diamond film is formed on a silicon single crystal substrate by a microwave plasma CVD or hot filament CVD process using hydrogen-diluted methane as a source gas. We have found that when a gaseous mixture of methane ($CH_4$) gas, hydrogen ($H_2$) gas and oxygen ($O_2$) gas is used as the source gas, and the proportions (% by volume) of the respective gases are set to fall in the ranges:

$$1.0\% \leq CH_4 \leq 8.0\%,$$
$$87.0\% \leq H_2 < 99.0\%, \text{ and}$$
$$0.0\% < O_2 \leq 5.0\%,$$

there is deposited a highly crystalline diamond film exerting a low or tensile stress, especially a tensile stress of $4.0 \times 10^9$ dyn/cm$^2$ or smaller. This diamond film is effective as a membrane for x-ray lithography. When film deposition is carried out while keeping the silicon single crystal substrate at a temperature of 900°C to 1,000°C, the tensile stress can be controlled. In summary, we have found that when diamond is deposited by the microwave plasma CVD or hot filament CVD process under controlled conditions including (1) the volume proportions of methane ($CH_4$), hydrogen ($H_2$) and oxygen ($O_2$) of the source gas and (2) the substrate temperature, a diamond film whose internal stress is controlled at a high precision can be produced without detracting from the crystallinity thereof.

We have further found the following. We measured films' hydrogen concentration [H] and oxygen concentration [O] at a depth of 0.5 $\mu$m from the surface, by secondary ion mass spectroscopy (SIMS). A film is more effective when the hydrogen and oxygen concentrations [H] and [O] fall in the ranges: $5.0 \times 10^{19}$ atoms/cm$^3$ s [H] $\leq 5.0 \times 10^{21}$ atoms/cm$^3$ and $2.0 \times 10^{18}$ atoms /cm$^3$ $\leq$ [O] $\leq 5.0 \times 10^{20}$ atoms/cm$^3$. The diamond film exhibits a peak attributable to diamond near 1333 cm$^{-1}$ and a peak attributable to amorphous carbon at 1530 cm$^{-1}$ as analyzed by laser Raman spectroscopy using a laser beam having a wavelength of 532 nm and a diameter of 150 $\mu$m. The film is more effective when the ratio of the intensity of the former peak to the intensity of the latter peak, I(1333cm$^{-1}$)/I(1530cm$^{-1}$), is in the range: $1.20 \leq$ I(1333cm$^{-1}$) /I(1530cm$^{-1}$) $\leq 1.50$. The diamond film exhibits a peak attributable to (111) oriented diamond at a diffraction angle (2$\theta$) of 43.9° and a peak attributable to (220) oriented diamond at a diffraction angle (2$\theta$) of 75.3° as analyzed by x-ray diffractometry at a wavelength λ of 1.54 Å. The film is more effective when the ratio of the intensity of the former peak to the intensity of the latter peak, I(111)/I(220), is in the range: $3.0 \leq I(111)/I(220) \leq 8.5$.

The invention provides a method as defined in claim 1 herein.

The x-ray lithography mask prepared by the above method has a hydrogen concentration [H] and an oxygen concentration [O] at a depth of 0.5 μm from its surface as measured by SIMS which fall in the ranges:

$$5.0 \times 10^{19} \text{ atoms/cm}^3 \leq [H] \leq 5.0 \times 10^{21} \text{ atoms/cm}^3$$

and

$$2.0 \times 10^{18} \text{ atoms/cm}^3 \leq [O] \leq 5.0 \times 10^{20} \text{ atoms/cm}^3.$$

The x-ray lithography mask prepared by the above method, when analyzed by laser Raman spectroscopy using a laser beam has a wavelength of 532 nm and a diameter of 150 μm, the diamond film exhibits a peak attributable to diamond near 1333 cm$^{-1}$ and a peak attributable to amorphous carbon at a Raman shift of 1530 cm$^{-1}$, and the ratio of the intensity of the former peak to the intensity of the latter peak, I(1333cm$^{-1}$)/I(1530cm$^{-1}$), is in the range: $1.20 \leq I(1333\text{cm}^{-1})/I(1530\text{cm}^{-1}) \leq 1.50$.

The x-ray lithography mask prepared by the above method, when analyzed by x-ray diffractometry at a wavelength λ of 1.54 Å, the diamond film exhibits a peak attributable to (111) oriented diamond at a diffraction angle (2θ) of 43.9° and a peak attributable to (220) oriented diamond at a diffraction angle (2θ) of 75.3°, and the ratio of the intensity of the former peak to the intensity of the latter peak, I(111)/I(220), is in the range: $3.0 \leq I(111)/I(220) \leq 8.5$.

### BRIEF DESCRIPTION OF THE DRAWINGS

The only figure, FIG. 1 is a cross-sectional view of a x-ray mask to which the diamond film of the invention is applicable.

### DETAILED DESCRIPTION

According to the invention, a diamond film for x-ray lithography is formed on a silicon single crystal substrate by a microwave plasma chemical vapor deposition (CVD) process or a hot filament CVD process. A gaseous mixture of methane (CH$_4$) gas and hydrogen (H$_2$) gas is conventionally used as a source gas. According to the invention, oxygen (O$_2$) gas is added to the source gas. The resulting source gas is a mixture consisting essentially of, in % by volume, 1.0% to 8.0% of methane gas, 87.0% to 99.0% of hydrogen gas, and at most 5.0% of oxygen gas, and preferably 1.0% to 7.5% of methane gas, 88.5% to less than 99.0% of hydrogen gas, and up to 4.0% of oxygen gas. If the proportions of the respective gases are outside the proposed ranges the resulting diamond film tends to be unsuitable for the diamond film to serve as an X-ray mask.

The quantity of oxygen is preferably at least such as to avoid compressive stress and more preferably to achieve tensile stress in the resulting diamond film under the deposition conditions used; this is easily determined by testing.

Except that the gas mixture of the above composition is used as the source gas, a diamond film can be formed on a silicon single crystal substrate according to a well-known diamond film forming method relying on the microwave plasma CVD or hot filament CVD process. If it is desired to induce a more tensile stress in the film, the silicon single crystal substrate is heated at a temperature in the range of 900°C to 1,000°C using a sintered or CVD silicon carbide heating element, for example. The heating of the substrate allows for fine adjustment of the stress in the film deposited thereon. High temperatures above 1,000°C can detract from the crystallinity of diamond.

The diamond film is usually deposited to a thickness of about 1 to 3 μm, especially about 2 μm. The tensile stress produced in the diamond film is preferably in the range of $4.0 \times 10^8$ Pa or smaller, especially $3.0 \times 10^8$ Pa or smaller.

With respect to impurities, the diamond film has a hydrogen concentration [H] and an oxygen concentration [O] in the film at a depth of 0.5 μm from its surface as measured by secondary ion mass spectroscopy (SIMS). The film becomes favorable when the hydrogen concentration [H] falls in the range:

$$5.0 \times 10^{19} \text{ atoms/cm}^3 \leq [H] \leq 5.0 \times 10^{21} \text{ atoms/cm}^3,$$

and more preferably

$$5.0 \times 10^{19} \text{ atoms/cm}^3 \leq [H] \leq 9.0 \times 10^{20} \text{ atoms/cm}^3,$$

and the oxygen concentration [O] falls in the range:

$$2.0 \times 10^{18} \text{ atoms/cm}^3 \leq [O] \leq 5.0 \times 10^{20} \text{ atoms/cm}^3,$$

and more preferably

$$2.0 \times 10^{18} \text{ atoms/cm}^3 \leq [O] \leq 4.0 \times 10^{20} \text{ atoms/cm}^3.$$

With respect to crystallinity, when the diamond film is analyzed by laser Raman spectroscopy using a laser beam having a wavelength of 532 nm and a diameter of 150 $\mu$m, it exhibits a peak attributable to diamond near 1333 cm$^{-1}$ having an intensity I(1333cm$^{-1}$) and a peak attributable to amorphous carbon at a Raman shift of 1530 cm$^{-1}$ having an intensity I(1530cm$^{-1}$). Better results are obtained when the peak intensity ratio, I(1333cm$^{-1}$)/I(1530cm$^{-1}$), is in the range:

$$1.20 \leq I(1333\text{cm}^{-1})/I(1530\text{cm}^{-1}) \leq 1.50,$$

and more preferably

$$1.25 \leq I(1333\text{cm}^{-1})/I(1530\text{cm}^{-1}) \leq 1.50.$$

Also with respect to crystallinity, when the diamond film is analyzed by x-ray diffractometry at a wavelength $\lambda$ of 1.54 Å, it exhibits a peak attributable to (111) oriented diamond at a diffraction angle (2$\theta$) of 43.9° having an intensity I(111) and a peak attributable to (220) oriented diamond at a diffraction angle (2$\theta$) of 75.3° having an intensity I(220). Better results are obtained when the peak intensity ratio, I(111)/I(220), is in the range:

$$3.0 \leq I(111)/I(220) \leq 8.5,$$

and more preferably

$$4.0 \leq I(111)/I(220) \leq 8.5.$$

By means of the new techniques described herein a diamond film having a sufficient crystallinity to serve as a membrane for X-ray lithography and a controlled tensile stress can be formed using a microwave plasma CVD or hot filament CVD process. This diamond film provides an X-ray mask with a good precision and lifetime.

EXAMPLE

Examples of the invention are given below by way of illustration .

Example 1

A both side polished silicon single crystal (100) wafer having a diameter of 3 inches and a thickness of 2,000 $\mu$m was used as the substrate. Prior to film deposition, the substrate on the surface was pretreated in a fluidized bed of diamond grits for the purpose of increasing the density of diamond nuclei. After the pretreatment, the substrate was mounted in a microwave plasma CVD chamber, which was evacuated to a base pressure of $10^{-3}$ Torr or lower by means of a rotary pump. Source gases, methane ($CH_4$), hydrogen ($H_2$), and oxygen ($O_2$) were introduced into the chamber at a rate of 45.0 cm$^3$/minute, 945.0 cm$^3$/minute, and 10.0 cm$^3$/minute, respectively. The volume ratio of the source gases was methane/hydrogen/oxygen = 4.5/94.5/1.0% by volume. After the chamber was set at 30 Torr by adjusting the opening of a valve in the vacuum pump system, microwaves with a power of 3,000 W were applied to create a plasma to deposit diamond for 37 hours. During film deposition, the substrate was heated solely with microwaves. On measurement by a pyrometer, the substrate surface was at 850°C.

There was deposited a diamond film of 3 $\mu$m thick. The film had a tensile stress of $0.2\times10^8$ Pa as calculated from the measurement of warpage of the substrate.

For quantitative determination of crystallinity, the diamond film was analyzed by x-ray diffractometry and laser spectroscopy. On analysis by an x-ray diffractometer RINT-1000 (Rigaku K.K.) at a wavelength $\lambda$ of 1.54 Å, the ratio of the intensity of a peak attributable to (111) oriented diamond at a diffraction angle ($2\theta$) of 43.9° to the intensity of a peak attributable to (220) oriented diamond at a diffraction angle ($2\theta$) of 75.3° was I(111)/I(220) = 6.2.

On analysis by a laser Raman spectrometer Holo Probe 532 (Kaiser Optical Systems) using a laser beam having a wavelength of 532 nm and a diameter of 150 $\mu$m, the ratio of the intensity of a peak attributable to diamond at 1333 cm$^{-1}$ to the intensity of a peak attributable to amorphous carbon at a Raman shift of 1530 cm$^{-1}$ was I(1333cm$^{-1}$)/I(1530cm$^{-1}$) = 1.40.

Impurities in the film, hydrogen and oxygen, were measured by a secondary ion mass spectrometer (SIMS) (ims-4f by Cameca). The primary ion used was Cs$^+$ ion at 14.5 eV. The hydrogen concentration [H] and oxygen concentration [O] at a depth of 0.5 $\mu$m from the outer surface of the diamond film were

$$[H] = 1.4 \times 10^{20} \text{ atoms/cm}^3$$

and

$$[O] = 1.4 \times 10^{19} \text{ atoms/cm}^3.$$

Finally, the silicon substrate was etched from the back surface over a central square area of 26 x 26 mm with an aqueous solution of KOH at 95°C, completing a membrane. The thus finished membrane was examined for resistance to SOR irradiation. First, SOR light having a center wavelength of 7 Å was locally irradiated to a rectangular area of 7 x 15 mm in a helium atmosphere of 1 atm. whereupon the in-plane distortion (IPD) of the membrane was measured by Nikon 3i meter (Nikon K.K.). The results showed that when SOR light was irradiated up to a dose of 100 kJ/cm$^2$, the maximum IPD was 15 nm, that is, within the reproducible measurement precision of the meter. The transmittance of light at a wavelength of 633 nm remained unchanged before and after the SOR irradiation.

Example 2

For the purpose of producing a film with a higher tensile stress than in Example 1, film deposition was carried out under the same conditions as in Example 1 by setting the substrate temperature at 970°C. Operation for 30 hours deposited a diamond film of 3 $\mu$m thick. The film had a tensile stress of 2.3x10$^8$ Pa.

Analysis by x-ray diffractometry and laser Raman spectroscopy gave the following results.

$$I(111)/I(220) = 5.5$$

$$I(1333cm^{-1})/I(1530cm^{-1}) = 1.32$$

The hydrogen and oxygen concentrations [H] and [O] at a depth of 0.5 $\mu$m from the outer surface of the diamond film were

$$[H] = 1.5 \times 10^{20} \text{ atoms/cm}^3$$

and

$$[O] = 2.0 \times 10^{19} \text{ atoms/cm}^3.$$

Finally, the silicon substrate was etched from the back surface over a central square area of 26 x 26 mm with an aqueous solution of KOH at 95°C, completing a membrane. The thus finished membrane was examined for resistance to SOR irradiation. After irradiation under the same conditions as in Example 1, the maximum IPD was 16 nm, that is, within the reproducible measurement precision of the meter. The transmittance of light at a wavelength of 633 nm remained unchanged before and after the SOR irradiation.

Comparative Examples

Using source gases as shown in Table 1, diamond films of 3 $\mu$m thick were formed by a microwave plasma CVD process under conditions as shown in Table 1. The stress and crystallinity of the films and the results of membranes fabricated therefrom are also shown in Table 1.

Table 1

| Microwave power (W) | Source gas $CH_4/H_2/O_2$ (vol%) | Pressure (Torr) | Substrate temperature (°C) | Stress (Pa) | Crystallinity | XRD intensity ratio, I (111)/ I (220) | Raman intensity ratio, I $(1333cm^{-1})$ / I $(1530cm^{-1})$ | Impurity concentration (atoms/cm$^3$) | Membrane formation | SOR resistance | |
|---|---|---|---|---|---|---|---|---|---|---|---|
| | | | | | | | | | | Maximum IPD | visible light transmission change |
| 2000 | 0.5/99.5/0.0 | 30 | 850 | $-2.1 \times 10^8$ compressive | good | 6.0 | 1.32 | [H] $1.7 \times 10^{20}$ [O] $2.5 \times 10^{19}$ | N.G. | membrane not formed with no measurement | |
| 3000 | 0.5/99.5/0.0 | 30 | 850 | $-2.3 \times 10^8$ compressive | good | 6.4 | 1.35 | [H] $1.5 \times 10^{20}$ [O] $2.1 \times 10^{19}$ | N.G. | | |
| 3000 | 0.5/99.4/0.1 | 30 | 850 | $-2,6 \times 10^8$ compressive | good | 7.0 | 1.40 | [H] $1.3 \times 10^{20}$ [O] $2.0 \times 10^{19}$ | N.G. | | |
| 3000 | 2.0/98.0/0.0 | 30 | 850 | $3.5 \times 10^7$ tensile | poor | 0.5 | 1.17 | [H] $8.5 \times 10^{21}$ [O] $3.0 \times 10^{19}$ | O.K. | 90 nm lowered | |
| 3000 | 5.0/95.0/0.0 | 30 | 850 | $3.0 \times 10^7$ tensile | poor | 0.2 | 1.13 | [H] $2.1 \times 10^{22}$ [O] $3.0 \times 10^{19}$ | O.K. | 185 nm lowered | |

EP 0 880 073 B1

It is evident from Table 1 that when source gas mixtures outside the scope of the invention are used, no diamond films satisfy the stress and crystallinity requirements at the same time.

**Claims**

1. A method comprising
preparing diamond films for X-ray lithography, including the step of forming diamond film by depositing diamond on a silicon single crystal substrate by a microwave plasma CVD or hot filament CVD process using hydrogen-diluted methane as a source gas, **characterised in that** oxygen gas is added to the source gas so that the resulting source gas consists essentially of from 1.0% to 8.0% by volume of methane, from 87.0% to less than 99.0% by volume of hydrogen gas and from more than 0.0% to at most 5.0% by volume of the oxygen gas, and
evaluating the diamond films for use in the preparation of an X-ray lithography mask, by any one of (a), (b) and (c):

(a) selecting those diamond films having a hydrogen concentration [H] and an oxygen concentration [O] at a depth of 0.5 $\mu$m from the surface as measured by SIMS which fall in the ranges:

$$5.0 \times 10^{19} \text{ atoms/cm}^3 \leq [H] \leq 5.0 \times 10^{21} \text{ atoms/cm}^3$$

and

$$2.0 \times 10^{18} \text{ atoms/cm}^3 \leq [O] \leq 5.0 \times 10^{20} \text{ atoms/cm}^3;$$

(b) analysing the diamond films by laser Raman spectroscopy using a laser beam having a wavelength of 532 nm and a diameter of 150 $\mu$m, and selecting those diamond films which exhibit a peak attributable to diamond near 1333 cm$^{-1}$ and a peak attributable to amorphous carbon at a Raman shift of 1530 cm$^{-1}$, the ratio of the intensity of the former peak to the intensity of the latter peak, I (1333cm$^{-1}$) /I (1530cm$^{-1}$), being in the range 1.20 $\leq$ I (1333cm$^{-1}$) /I (1530cm$^{-1}$) $\leq$ 1.50;
(c) analysing the diamond films, by X-ray diffractometry at wavelength $\lambda$ of 1.54 Å, and selecting those diamond films which exhibit a peak attributable to (111) oriented diamond at a diffraction angle (2$\theta$) of 43.9° and a peak attributable to (220) oriented diamond at a diffraction angle (2$\theta$) of 75.3°, the ratio of the intensity of the former peak to the intensity of the latter peak, I(111)/I(220), being in the range 3.0 $\leq$ I(111)/I(220) $\leq$ 8.5.

2. A method according to claim 1 in which the silicon single crystal substrate is heated at a temperature of from 900 to 1,000°C while the diamond is deposited thereon.

3. A method according to claim 1 or 2
in which the source gas contains not more than 7.5% of methane gas, 88.5% to less than 99.0% of hydrogen gas, and not more than 4.0% of oxygen gas.

4. A method according to according to any one of the preceding claims in which the films are deposited to a thickness of from 1 to 3 $\mu$m.

**Patentansprüche**

1. Verfahren, umfassend:

die Herstellung von Diamantfilmen für Röntgenlithographien, einschließlich des Schrittes der Ausbildung eines Diamantfilms durch das Abscheiden von Diamant auf einem Siliciumeinkristallsubstrat mittels eines Mikrowellenplasma-CVD- oder Heißdraht-CVD-Verfahrens unter Einsatz von mit Wasserstoff verdünntem Methan als Quellgas, **dadurch gekennzeichnet, dass** Sauerstoffgas zu dem Quellgas zugesetzt wird, sodass das resultierende Quellgas im Wesentlichen aus 1,0 bis 8,0 Vol.-% Methan, 87,0 bis weniger als 99,0 Vol.-% Wasserstoffgas und mehr als 0,0 bis maximal 5,0 Vol.-% Sauerstoffgas besteht, und

die Bewertung der Diamantfilme zur Verwendung zur Herstellung einer Röntgenlithographie-Maske durch ein aus (a), (b) und (c) ausgewähltes Verfahren:

(a) Auswählen der Diamantfilme, die in einer Tiefe von 0,5 $\mu$m von der Oberfläche aus, gemessen mittels SIMS, eine Wasserstoffkonzentration [H] und eine Sauerstoffkonzentration [O] aufweisen, die in folgende Bereiche fallen:

$$5,0 \times 10^{19} \text{ Atome/cm}^3 \leq [H] \leq 5,0 \times 10^{21} \text{ Atome/cm}^3$$

und

$$2,0 \times 10^{18} \text{ Atome/cm}^3 \leq [O] \leq 5,0 \times 10^{20} \text{ Atome/cm}^3;$$

(b) Analysieren der Diamantfilme mittels Laser-Raman-Spektroskopie unter Einsatz eines Laserstrahls mit einer Wellenlänge von 532 nm und einem Durchmesser von 150 $\mu$m und Auswählen jener Diamantfilme, die einen Peak, der Diamant zuzuschreiben ist, nahe 1333 cm$^{-1}$ und einen Peak, der amorphem Kohlenstoff zuzuschreiben ist, bei einer Raman-Verschiebung von 1530 cm$^{-1}$ aufweisen, wobei das Verhältnis der Intensität des ersten Peaks zu der Intensität des zweiten Peaks, I(1333 cm$^{-1}$)/I(1530 cm$^{-1}$), im Bereich 1,20 $\leq$ I(1333 cm$^{-1}$)/I(1530 cm$^{-1}$) $\leq$ 1,50 liegt;

(c) Analyse des Diamantfilms mittels Röntgendiffraktometrie mit einer Wellenlänge $\lambda$ von 1,54 Å und Auswahl jener Diamantfilme, die einen Reflex, der (111)-orientiertem Diamant zuzuordnen ist, bei einem Beugungswinkel (2$\theta$) von 43,9° und einen Reflex, der (220)-orientiertem Diamant zuzuordnen ist, bei einem Beugungswinkel (2$\theta$) von 75,3° aufweisen, wobei das Verhältnis der Intensität des ersten Reflexes zu der Intensität des zweiten Reflexes, I(111)/I(220), im Bereich 3,0 $\leq$ I(111)/I(220) $\leq$ 8,5 liegt.

**2.** Verfahren nach Anspruch 1, worin das Siliciumeinkristallsubstrat auf eine Temperatur von 900 bis 1.000 °C erhitzt wird, während der Diamant darauf abgeschieden wird.

**3.** Verfahren nach Anspruch 1 oder 2, worin das Quellgas nicht mehr als 7,5 % Methangas, 88,5 % bis weniger als 99,0 % Wasserstoffgas und nicht mehr als 4,0 % Sauerstoffgas enthält.

**4.** Verfahren nach einem der vorangegangenen Ansprüche, worin die Filme in einer Dicke von 1 bis 3 $\mu$m abgeschieden werden.

**Revendications**

**1.** Procédé comprenant les étapes consistant à
préparer des films de diamant pour une lithographie aux rayons X, comprenant l'étape consistant à former un film de diamant par dépôt de diamant sur un substrat monocristallin de silicium par un procédé de dépôt chimique en phase vapeur par plasma hyperfréquence ou un procédé de dépôt chimique en phase vapeur au filament chaud utilisant du méthane dilué dans de l'hydrogène comme gaz source, **caractérisé en ce que** l'oxygène gazeux est ajouté au gaz source de sorte que le gaz source résultant est constitué essentiellement de 1,0 % à 8,0 % en volume de méthane, de 87,0 % à moins de 99,0 % en volume d'hydrogène gazeux et de plus de 0,0 % à au plus 5,0 % en volume d'oxygène gazeux, et
évaluer les films de diamant pour une utilisation dans la préparation d'un masque de lithographie aux rayons X, par l'un quelconque de (a), (b) et (c) :

(a) sélectionner ces films de diamant ayant une concentration en hydrogène [H] et une concentration en oxygène [O] à une profondeur de 0,5 $\mu$m à partir de la surface comme mesuré par spectrométrie de masse des ions secondaires (SIMS) qui entrent dans les plages :

$$5,0 \times 10^{19} \text{ atomes/cm}^3 \leq [H] \leq 5,0 \times 10^{21} \text{ atomes/cm}^3$$

et

$$2,0 \times 10^{18} \text{ atomes/cm}^3 \leq [O] \leq 5,0 \times 10^{20} \text{ atomes/cm}^3 \text{ ;}$$

(b) analyser les films de diamant par spectroscopie Raman à laser en utilisant un faisceau laser ayant une longueur d'onde de 532 nm et un diamètre de 150 $\mu$m, et sélectionner les films de diamant qui présentent un pic pouvant être attribué au diamant proche de 1 333 cm$^{-1}$ et un pic pouvant être attribué au carbone amorphe à un décalage Raman de 1 530 cm$^{-1}$, le rapport de l'intensité du premier pic sur l'intensité du dernier pic, I(1 333 cm$^{-1}$)/I(1 530 cm$^{-1}$) étant dans la plage de 1,20 ≤ I (1 333 cm$^{-1}$)/I(1 530 cm$^{-1}$) ≤ 1,50 ;

(c) analyser les films de diamant, par diffractométrie de rayons X à une longueur d'onde $\lambda$ de 1,54 Å, et sélectionner les films de diamant qui présentent un pic pouvant être attribué à un diamant orienté (111) selon un angle de diffraction (2$\theta$) de 43,9° et un pic pouvant être attribué à un diamant orienté (220) selon un angle de diffraction (2$\theta$) de 75,3°, le rapport de l'intensité du premier pic sur l'intensité du dernier pic, I(111)/I(220), étant dans la plage de 3,0 ≤ I(111)/I(220) ≤ 8,5.

2. Procédé selon la revendication 1, dans lequel le substrat monocristallin de silicium est chauffé à une température de 900 à 1000 °C tandis que le diamant est déposé dessus.

3. Procédé selon la revendication 1 ou 2, dans lequel le gaz source ne contient pas plus de 7,5 % de méthane gazeux, 88,5 % à moins de 99,0 % d'hydrogène gazeux, et pas plus de 4,0 % d'oxygène gazeux.

4. Procédé selon l'une quelconque des revendications précédentes, dans lequel les films sont déposés à une épaisseur de 1 à 3 $\mu$m.

# FIG.1